# EUROPÄISCHE PATENTSCHRIFT

(11) **EP 2 434 344 B1**
(45) Veröffentlichungstag und Bekanntmachung des Hinweises auf die Patenterteilung: **13.03.2013**
(21) Anmeldenummer: 11007631.2
(22) Anmeldetag: 20.09.2011
(51) Int. Cl.: G03F 7/038, G03F 7/039

(54) **Fotolithografisches Verfahren zum Ausbilden einer dreidimensionalen Struktur**
Photolithographic method for depicting a three-dimensional structure
Procédé photolithographique pour la formation d'une structure tridimensionnelle

(30) Priorität: 24.09.2010 DE 102010046730
(43) Veröffentlichungstag der Anmeldung: 28.03.2012
(73) Patentinhaber: Helmholtz-Zentrum Berlin für Materialien und Energie GmbH, 14109 Berlin (DE)
(72) Erfinder: Mertsch, Olaf, 12524 Berlin (DE); Mertsch, Antje, 12524 Berlin (DE)

(56) Entgegenhaltungen:
- WO-A1-2004/057425
- US-A1- 2003 008 246
- US-A1- 2007 034 599

## Beschreibung

Die Erfindung bezieht sich auf ein fotolithografisches Verfahren zum Ausbilden einer dreidimensionalen Struktur in einer Fotolackschicht mit den Verfahrensschritten
- Bereitstellen einer Fotolackschicht aus einem chemisch verstärkten Fotolack mit mindestens einem Fotosäuregenerator zur Erzeugung von freien Ladungsträgern bei Belichten oberhalb einer Schwellwertdosis,
- Belichten zumindest eines Belichtungsfelds der Fotolackschicht mit einer stufenweise oder kontinuierlich veränderbaren Belichtungsdosis oberhalb der Schwellwertdosis des Fotosäuregenerators,
- Anregen einer orientierten Wanderung der freien Ladungsträger in der Fotolackschicht durch Anlegen zumindest eines in seiner Polung und seiner Feldstärke einstellbaren elektrischen Feldes an die Fotolackschicht, wobei die freien Ladungsträger eine Vernetzung der Fotolackschicht bewirken, und
- Entwickeln der vernetzten Fotolackschicht durch Entfernen der löslichen Bestandteile der Fotolackschicht.

Die Fotolithografie (auch Photolithographie) ist ein lithografisches Reproduktionsverfahren, bei dem mittels Belichtung mehrdimensionale Strukturen auf und in unterschiedlichen Materialien generiert werden. Dabei können Masken oder Substrate aus Fotolack erzeugt oder Fotolack durch Masken hindurch belichtet werden. Maskenstrukturen können durch Ätztechniken in ein Substrat übertragen werden. In der Mikrotechnik treten vorwiegend "2 ½-dimensionale" Strukturen, das heißt von durch senkrechte Seitenwände begrenzte Strukturen mit einer oder wenigen Stufenhöhen, und primitive "echte" 3-dimensionale Strukturen auf, die aber nur selten auch design- und nicht nur prozessgetriebene schräge Ebenen und gekrümmte Flächen aufweisen. Komplexe mehrdimensionale Mikrostrukturen mit kontinuierlichen Höhenniveaus an Stelle von diskreten, im Extremfall berandet von Freiformflächen, sind derzeit noch nicht zufrieden stellend herstellbar. Dabei sind für mechanische Mikrostrukturen verrundete Übergänge günstiger in Bezug auf Eigenschaften wie verminderte Kerbwirkung und niedrigere träge Masse bei hoher Festigkeit bzw. Steifigkeit. Für fluidische Mikrostrukturen sind verschliffene Verläufe vorteilhafter im Hinblick auf die Vermeidung von Kavitäten. Auch erfordert die technische Umsetzung von Konstruktions-, Verfahrens- und Entwicklungsprinzipien biologischer Systeme in der Bionik häufig kontinuierliche, komplexe dreidimensionale Strukturen. Für deren Herstellung wird beispielsweise die Grauton-Lithografie angewendet. Dabei können spezielle Masken mit Strukturen (Grauton-Masken) verwendet werden, die kleiner sind als die Auflösungsgrenze des Projektionsobjektives. Dadurch wird eine Helligkeitsmodulation im Bildbereich erreicht, die von einem Fotolack in entsprechende 3D-Strukturen abgebildet wird. Weiterhin können Beugungs- und Interferenzeffekte an Maskenschlitzen genutzt werden. Der Fotolack kann aber auch maskenfrei mit einem intensitätsmodulierten. Energiestrahl oder durch Variation der Fokustiefe direkt belichtet werden, wobei zur Belichtung auch Elektronen-oder Protonenstrahlen eingesetzt werden.

Neben der Art der Belichtung spielt bei der Fotolithografie insbesondere der Fotolack eine wichtige Rolle. Zur Erhöhung der Empfindlichkeit und Auflösung des Fotolacks beruhen die heutzutage verwendeten Fotolacke auf dem Prinzip der chemischen Verstärkung (CAR, chemical amplification resists). Diese Lacke bestehen in der Regel aus einem Polymer, einem Fotosäuregenerator (Photo Acid Generator PAG, photoaktive Komponente PAK oder auch Fotoinitiatorsalz) und einem Lösungsmittel. In diesen Lacken kommt der photoaktiven Komponente, die nicht im Polymer eingebunden ist, eine entscheidende Rolle bei der Erhöhung der Empfindlichkeit zu. Diese Fotosäuregeneratoren sind entweder ionische oder kovalente Verbindungen, die durch Bestrahlung oberhalb einer Schwellwertdosis mit Licht (UV, DUV, EUV), Elektronen oder lonen eine starke Säure freisetzen. lonische Fotosäuregeneratoren bestehen aus neutralen Fotosäuremolekülen, in der Regel ein Salz, das aufgrund photoaktiver Bestandteile im Molekül (Elektronen im Benzolring, die auf die Anregung durch insbesondere UV-Licht reagieren können) unter Belichtung in freie Ladungsträger in Form von Kationen und Anionen aufgespalten wird. Diese Spaltprodukte können durch den Fotolack wandern, bevor sie eine Vernetzung im Polymer hervorrufen. Dabei ist es vom verwendeten Fotolack abhängig, welcher freie Ladungsträger die Vernetzung bewirkt. Bei SU8, einem polymeren Negativresist auf Epoxidharz-Basis, ist für die Vernetzung das Kation verantwortlich, bei dem es sich um ein freies Wasserstoffion, allgemein auch als Proton bezeichnet, handelt. Das Kation (Proton) kann in der Epoxydharzmatrix wandern und führt zur Vernetzung der einzelnen SU8-Monomere. Dabei handelt es sich bei dem Protonenwanderungsprozess um ein Model. Da die Protonen dieser Theorie zufolge vollkommen ungerichtet durch den Fotolack wandern, ist die Vernetzung durch eine netzartige, poröse Struktur des Fotolacks nach der Entwicklung darstellbar. Diese netzartige Struktur wird in der Veröffentlichung "Nanoporöse und ultra-hydrophobe Strukturen im Negativresist SU8" (Olaf Mertsch, Dissertation, TU Berlin 2008, Seiten 117 bis 132, Abbildungen 50, 52 und 56) näher untersucht und durch entsprechende REM-Bilder nachgewiesen. Dabei zeigen die Bilder die Ergebnisse des stochastischen Protonenwanderungsprozesses.

Das Polymer enthält eine so genannte "Schutzgruppe" (oder Lösungsinhibitor), die mit den in den belichteten Bereichen aus dem Fotosäuregenerator freigesetzten Fotosäuremolekülen reagiert. Dies wird in einem nach der Belichtung stattfindenden Heizschritt begünstigt (Post Exposure Bake, PEB). Es gibt unterschiedliche funktionelle Gruppen, die als Schutzgruppe fungieren können, wie z.B. Ester, Ether, Carbonate und Acetate. Daraus resultiert eine starke Änderung der Polarität, die bei einem Positivlack die Entfernung der belichteten Stellen in einem wässrigen alkalischen Lösungsmittel (Entwicklungsschritt) ermöglicht. Auf dieser Weise werden die erwünschten Strukturen erzeugt. Da diese Spaltungen katalytisch ablaufen (bei SU8 steht das Kation (Proton) nach der Bindungsspaltung wieder zur Verfügung), können bereits geringe Mengen Säure eine starke Polaritätsveränderung am Polymer hervorrufen. Dieser Prozess wird als "chemische Verstärkung" bezeichnet. Durch die Polymerisation wird die Fotosäure regeneriert. Ein einzelnes Photon kann somit eine Reihe von Polymerisationen auslösen, was die hohe Fotoempfindlichkeit von chemisch verstärkten Fotolacken bedingt. Bei der Verwendung eines solchen Lacks werden die Monomere also nicht direkt durch die eingestrahlte Energie vernetzt, sondern erst durch die von dem Fotosäuregenerator erzeugten Fotosäuren bzw. deren Spaltprodukte in Form der freien Ladungsträger. Die eigentliche Vernetzung (Polymerisation) findet bei chemisch verstärkten Fotolacken erst durch einen sekundären Prozess statt.

### STAND DER TECHNIK

Ein sehr häufig verwendeter chemisch verstärkter (Negativ-)Fotolack ist SU-8 der Firma MicroChem, der mit Kationen (Protonen) zur Vernetzung arbeitet. Aus dem Übersichtsartikel "SU-8: a photoresist for high-aspect ratio and 3D submicron lithography" (A. del Campo et al., J. Micromech. Microeng. 17 (2007) R81-R95) ist auch dessen Eignung für direktes Schreiben mit einem Protonenstrahl (Kap. 5.4, für "binäre" Strukturen mit hohem Aspektverhältnis) und für maskengebundene Grauton-Lithografie bekannt (Kap. 6.3, kontinuierliche 3D-Strukturen). In einer weiteren Veröffentlichung "Considerations on using SU-8 as a construction material for high aspect ratio structures" (J. Melai et al., paper 10th Annual Workshop on Semiconductor Advances for Future Electronics and Sensors (SAFE), 29-30 Nov. 2007, Veldhoven, NL) werden die dielektrischen Eigenschaften (Leckstrom, Kapazität) von SU-8 durch Anlegen einer strukturierten Anode und einer strukturierten Kathode untersucht. Dabei wird ein fotolithografischer Prozess aber nur eingesetzt, um Bereiche des Fotolacks außerhalb der Elektroden zu entfernen. Eine lithografische Strukturierung des Fotolacks zwischen den beiden Elektroden unter gleichzeitigem Anlegen eines elektrischen Feldes an den Fotolack zwischen den beiden Elektroden findet nicht statt.

Weiterhin ist es aus der DE 10 2008 007 665 A1 bekannt, mit Grauton-Lithografie fingerförmige Elektroden als Produkt mit einer binären Struktur mit hohem Aspektverhältnis für ein mikromechanisches Bauteil zu erzeugen. Dabei wird aber während der Durchführung des lithografischen Verfahrens keine Spannung angelegt. Ebenfalls ohne Spannung wird ein mikromechanischer Aktuator gemäß der DE 199 56 654 A1 mit einer gekrümmten Fläche mittels Grauton-Lithografie hergestellt, wobei nach der Strukturierung auf die gekrümmte Fläche eine Metallschicht als Elektrode aufgebracht wird.

Aus der US 2010/0096674 A1 ist ein Verfahren zur Herstellung eines Driftdetektors für die Röntgenstrahl-Spektroskopie bekannt. Dabei wird zunächst mit Grauton-Lithografie und Maskenübertragung durch trockenes Elektronenstrahl-Ätzen eine konzentrische Grabenstruktur in einem dotierten Halbleiter erzeugt und anschließend an die als Driftelektroden nutzbaren Stege unterschiedliche Spannungen angelegt, um eine Verarmung der Dotieratome in den Stegen hervorzurufen. Auch aus dieser Druckschrift wird jedoch während der Durchführung des Grauton-Lithografieverfahrens keine Spannung angelegt. In allen Druckschriften werden jeweils relativ einfache, vorwiegend binäre dreidimensionale Strukturen erzeugt.

Eine Anregung der Wanderung der freien Ladungsträger durch ein elektrisches Feld ist beispielsweise aus der US 5 158 861 A bekannt. Zur Verstärkung der vertikalen Wanderung der freien Ladungsträger durch die Fotolackschicht wird ein vertikales elektrisches Gleichfeld angelegt. Laterale Wanderungen, die negative Strukturen erzeugen können, sollen vermieden werden. Ein ähnliches Verfahren ist aus der US 2006/0189146 A1 bekannt. Zur Erzielung einer vertikalen Wanderung wird vor oder während der Erwärmung ein elektrisches Feld angelegt. Schließlich ist es aus der US 2008/0008967 A1 bekannt, zur Erzielung anisotroper, also gerichteter Diffusion während der Erwärmung ein elektrisches Feld anzulegen. In beiden zuletzt genannten Druckschriften werden aber nicht explizit chemisch verstärkte Fotolacke erwähnt, sodass von entsprechend geringen Ladungsträgeranzahlen auszugehen ist.

Der der Erfindung nächstliegende Stand der Technik wird in der US 2003/0008246 A1 offenbart, in der das gattungsgemäße fotolithografische Verfahren beschrieben wird. In eine Fotolackschicht aus einem chemisch verstärkten Fotolack mit einem Fotosäuregenerator zur Erzeugung von freien Ladungsträgern bei Belichten oberhalb einer Schwellwertdosis sollen binäre dreidimensionale Strukturen erzeugt werden. Dazu wird zunächst ein Belichtungsfeld der Fotolackschicht mit einer Belichtungsdosis oberhalb der Schwellwertdosis selektiv bestrahlt. Die Belichtungsdosis ist dabei auch stufenweise oder kontinuierlich veränderbar (Grautonlithografie). Nach dem Belichten wird die Fotolackschicht einer Wärmebehandlung unterzogen. Während der Wärmebehandlung werden die durch die Belichtung erzeugten freien Ladungsträger in der Fotolackschicht zu einer orientierten Wanderung angeregt. Dies erfolgt durch Anlegen eines elektrischen Wechselfelds, das in seinen Parametern Frequenz (also Polung) und Spannung (also Feldstärke) einstellbar ist. Die stationären freien Ladungsträger bewirken eine Vernetzung der Fotolackschicht. Die vernetzte Fotolackschicht wird dann durch Entfernen der löslichen Bestandteile der Fotolackschicht entwickelt. Die bekannten Strukturen werden ausschließlich durch die Belichtung des Fotolacks erreicht, dabei sollen die Strukturwände möglichst vertikal verlaufen (binär-dreidimensionale Strukturen). Das elektrische Feld wird also auch hier nur zur Unterdrückung unerwünschter Diffusion der freien Ladungsträger eingesetzt.

### AUFGABENSTELLUNG

Die Aufgabe für die vorliegende Erfindung ist darin zu sehen, ein gattungsgemäßes fotolithografisches Verfahren anzugeben, mit dem in einfacher und kostengünstiger Weise konkret vorgegebene, auch komplexe, d.h. nicht nur binäre dreidimensionale Strukturen in einer Fotolackschicht erzeugt werden können. Die erfindungsgemäße Lösung für diese Aufgabe ist dem Hauptanspruch zu entnehmen, vorteilhafte Weiterbildungen der Erfindung werden in den Unteransprüchen aufgezeigt und im Folgenden im Zusammenhang mit der Erfindung näher erläutert.

Das erfindungsgemäße fotolithografische Verfahren ist durch ein Anregen der orientierten Wanderung der freien Ladungsträger in der Fotolackschicht rechtwinklig zur Belichtungsrichtung durch Anlegen zumindest eines in seiner Polung und seiner Feldstärke einstellbaren elektrischen Feldes an die Fotolackschicht rechtwinklig zur Belichtungsrichtung und durch eine Koordination des Einstellens des zumindest einen elektrischen Felds mit dem stufenweise oder kontinuierlich veränderbaren Belichten des zumindest einen Belichtungsfelds der Fotolackschicht charakterisiert. Dabei wird während des stufenweise oder kontinuierlich veränderbaren Belichtens das zumindest eine angelegte elektrische Feld so in seiner Polung und/oder Feldstärke eingestellt, dass durch die angeregte orientierte Wanderung der freien Ladungsträger konvexe, konkave, konisch geformte, ansteigende oder mäanderförmige dreidimensionale Strukturen ausgebildet werden. Das erfindungsgemäße fotolithografische Verfahren ist also dadurch gekennzeichnet, dass durch Anlegen zumindest eines elektrischen Feldes an die Fotolackschicht rechtwinklig zur Belichtungsrichtung eine gezielt beeinflussbare orientierte Wanderung der erzeugten freien Ladungsträger (lonen, d.h. Kationen und Anionen) in der Fotolackschicht rechtwinklig zur Belichtungsrichtung erreicht wird. Mit dem Verfahren wird somit eine gerichtete Elektrodiffusion der freien Ladungsträger im Fotolack bewirkt, die sich - im Gegensatz zum Stand der Technik - nicht in Richtung der Belichtung erstreckt, sondern rechtwinklig dazu. Dadurch können mit dem erfindungsgemäßen Lithografieverfahren auch schräge, gestufte, abgesetzte oder gebogene Seitenwände, Einschlüsse oder Unterschneidungen in der Struktur hochgenau erzeugt werden. Möglich wird dies durch die unter Belichtung photoaktiven Komponenten (Fotosäure-Moleküle) bzw. deren Spaltprodukte in Form von Kationen oder Anionen als freie Ladungsträger (lonen). Diese lonen können bei der Erfindung durch elektrische Felder, die an den Fotolack angelegt werden, im Fotolack entsprechend ihrer Ladung beliebig, aber orientiert in Richtung auf den Plus- bzw. Minuspol (je nach Ladungsart des freien Ladungsträgers) des elektrischen Felds verschoben werden. Dadurch können bereits während der Belichtung und der startenden Vernetzungsreaktion gezielt Bereiche mit verarmter oder erhöhter Konzentration an freien Ladungsträgern erreicht werden und somit das Belichtungsbild bzw. die dreidimensionale Strukturform in Bezug auf herkömmliche Fotolithografie bzw. herkömmliche Grauton-Fotolithografie durch unterschiedliche Vernetzungsgrade deutlich beeinflusst und verändert werden.

Die spannungsinduzierte Unterstützung der Wanderung der Fotosäure-Moleküle und deren Spaltprodukte (Kationen, Anionen) erfolgt bei der Erfindung während des Belichtungsprozesses, da dann die Mobilität der Spaltprodukte noch am größten ist und die Vernetzung gerade erst beginnt. Aber auch während einer Erwärmung der Fotolackschicht (Backen), die eine unorientierte Wanderung der Fotosäuremoleküle und Spaltprodukte hervorruft, kann bevorzugt eine spannungsinduzierte orientierte Wanderung nach der Erfindung überlagert werden. Bei bekannten fotolithografischen Verfahren werden in der Regel Erwärmungsschritte (Soft- oder Hard-Bake-Prozesse) eingesetzt, um Lösungsmittel aus der Fotolackschicht auszutreiben und eine unorientierte (thermische) Wanderung der Spaltprodukte (Fotosäuren) zur möglichst homogenen Vernetzung des Fotolacks hervorzurufen. Vorteilhaft kann bei der Erfindung also nicht nur während der Belichtung sondern auch während einer Erwärmung ein elektrisches Feld an die Fotolackschicht angelegt werden. Dabei kann je nach Orientierung und Stärke der angelegten elektrischen Felder die unkontrollierte thermische Wanderung der Fotosäure-Moleküle und deren Spaltprodukte vollständig unterbunden, in eine frei wählbare Richtung verstärkt oder mehr oder weniger stark überlagert und zugelassen werden.

Der einfachste Fall im Verfahren nach der Erfindung sieht das Anlegen eines einzigen elektrischen Feldes mit gegenüberliegenden Elektroden vor, sodass die Fotosäure-Moleküle und Spaltprodukte (lonen) zu einer geradlinigen Wanderung angeregt werden. Die beide Elektroden und die Fotolackschicht sind dann nach Art eines Kondensators geschichtet. Wird beispielsweise noch ein zweites elektrisches Feld vorgesehen, dessen beide Elektroden senkrecht zu den beiden ersten Elektroden angeordnet sind, so kann durch entsprechende Abstimmung zwischen den beiden Elektrodenpaaren beispielsweise eine mäanderförmige Wanderung der Fotosäure-Moleküle und Spaltprodukte hervorgerufen werden (senkrechte Anordnung der elektrischen Felder). Beliebige Kombinationen mehrerer elektrischer Felder - auch mit beliebigen Elektrodenanordnungen - sind realisierbar. Es können beispielsweise auch mehrere elektrische Felder parallel übereinander angelegt werden, indem verschiedene Elektroden mit Isolationen übereinander geschichtet werden können (parallele Anordnung der elektrischen Felder). Weitere Details zu den verschiedenen Möglichkeiten der Felderzeugung sind dem speziellen Beschreibungsteil zu entnehmen.

Die besonders einfache Möglichkeit der gezielten Beeinflussung der Wanderung der Fotosäure-Moleküle und deren ladungstragenden Spaltprodukte in einem elektrischen Feld ergibt sich, wenn zumindest ein veränderliches elektrisches Feld mit einstellbarer Polung und/oder Feldstärke angelegt wird. Dabei kann eine zeitlich konstante Polung (elektrostatisches Feld) oder eine wechselnde Polung (elektrisches Wechselfeld mit einstellbarer Umpolungsfrequenz) gewählt werden. Bei einem elektrostatischen Feld werden die Fotosäure-Moleküle und freien Ladungsträger gezielt dauerhaft in eine Richtung (negativ geladene Anionen in Richtung auf den Pluspol, positiv geladene Kationen und Protonen in Richtung auf den Minuspol) verschoben. Bei einem Wechselfeld kommt es je nach gewählter Umpolungsfrequenz zu einer Umkehr der Orientierung. Dabei kann die Umpolung manuell (niedrige Frequenz) oder automatisch (hohe Frequenz) erfolgen. Wenn vorteilhaft bei dem Verfahren nach der Erfindung eine Veränderung der relativen Lage zwischen der Fotolackschicht und dem elektrischen Feld während des Anregens der orientierten Wanderung der Fotosäure-Moleküle und freien Ladungsträger in der Fotolackschicht vorgesehen ist, kann die Umpolung beispielsweise zu einem zick-zack-förmigen Verlauf der wandernden lonen und damit der Vernetzungsbereiche genutzt werden. Die Geschwindigkeit der Wanderung der lonen kann durch die Feldstärke des angelegten elektrischen Felds beeinflusst werden. Dabei kann vorteilhaft eine zeitlich konstante Feldstärke gewählt werden, sodass sich eine konstante Geschwindigkeit ergibt. Eine veränderliche Geschwindigkeit mit gezielten Beschleunigungs- und/oder Verlangsamungsphasen der wandernden lonen kann vorteilhaft durch Aufprägen einer zeitlich veränderlichen Feldstärke erreicht werden.

Dreidimensionale Strukturen mit Rippenausbildungen, die unterschiedliche, beispielsweise gegenläufig gekrümmte Flanken aufweisen, können bei der Erfindung dadurch erhalten werden, dass unterschiedliche Belichtungsfelder der Fotolackschicht belichtet werden. So können beispielsweise Rippen mit zwei gegenläufig gekrümmten Flanken erzeugt werden. Nähere Details sind den Ausführungsbeispielen zu entnehmen.

Allgemein bekannt sind Grauton-Lithografieverfahren mit einer Veränderung der Belichtungsdosis. Durch die unterschiedliche Belichtungstiefe aufgrund der variierenden Belichtungsdosis können entsprechende dreidimensionale Strukturen, in der Regel binäre Strukturen, erzeugt werden. Dieses Vorgehen wird auch bei der Erfindung angewendet. Es wird mit einer stufenweise oder kontinuierlich veränderbaren Belichtungsdosis oberhalb der Schwellwertdosis belichtet (Grautonlithografie). Dabei können die Verfahrensschritte auch alternieren, sodass hochkomplexe Strukturen, die abschnittsweise nur durch Veränderung der Belichtungsdosis, abschnittsweise nur durch Anlegen zumindest eines elektrischen Felds und/oder abschnittsweise durch Überlagerung der beiden Maßnahmen erzeugt werden. Beliebige Kombinationen sind wiederum möglich. Ebenfalls kann vorteilhaft natürlich auch eine Belichtung durch eine Belichtungsmaske hindurch erfolgen. Hierbei überlagern sich dann noch Strukturierungseffekte aufgrund von Beugung und Interferenz. Des Weiteren kann auch eine veränderliche Fokussierung des belichtenden Lichtstrahls durch eine entsprechende Maske oder Optik überlagert werden.

In Abhängigkeit von der Wahl des eingesetzten Fotolacks kann vorteilhaft auch eine Belichtung mit UV-Licht erfolgen. Vorteilhaft kann beispielsweise ein Negativ-Fotolack aus der SU8-Familie der Firma MicroChem eingesetzt werden. Grundsätzlich kann eine Fotolackschicht aus einem Positiv-Fotolack mit einer Entfernung der belichteten Bereiche bei der Entwicklung oder aus einem Negativ-Fotolack mit einer Entfernung der unbelichteten Bereiche verwendet werden. Schließlich kann vorteilhaft eine Fotolackschicht auf einem Substrat, beispielsweise einem Silizium-Substrat, in das die Struktur durch anschließendes Ätzen übertragen werden soll, oder als freitragende Fotolackfolie, beispielsweise zur Herstellung von Membranen, bereitgestellt werden. Weitere Ausführungsformen der Erfindung sind den nachfolgenden Ausführungsbeispielen zu entnehmen.

### AUSFÜHRUNGSBEISPIELE

Ausbildungsformen des fotolithografischen Verfahrens zum Ausbilden einer dreidimensionalen Struktur in einer Fotolackschicht nach der Erfindung werden nachfolgend zum weiteren Verständnis der Erfindung näher erläutert. Dabei zeigt:
- **FIGUR 1**: einen Querschnitt durch eine Fotolackschicht mit Isodosislinien und freien Ladungsträgern,
- **FIGUR 2**: die Fotolackschicht in einem elektrischen Feld,
- **FIGUREN 3A, 3B, 3C**: mögliche erreichbare Strukturformen und
- **FIGUREN 4A, 4B**: mögliche Elektrodenanordnungen.

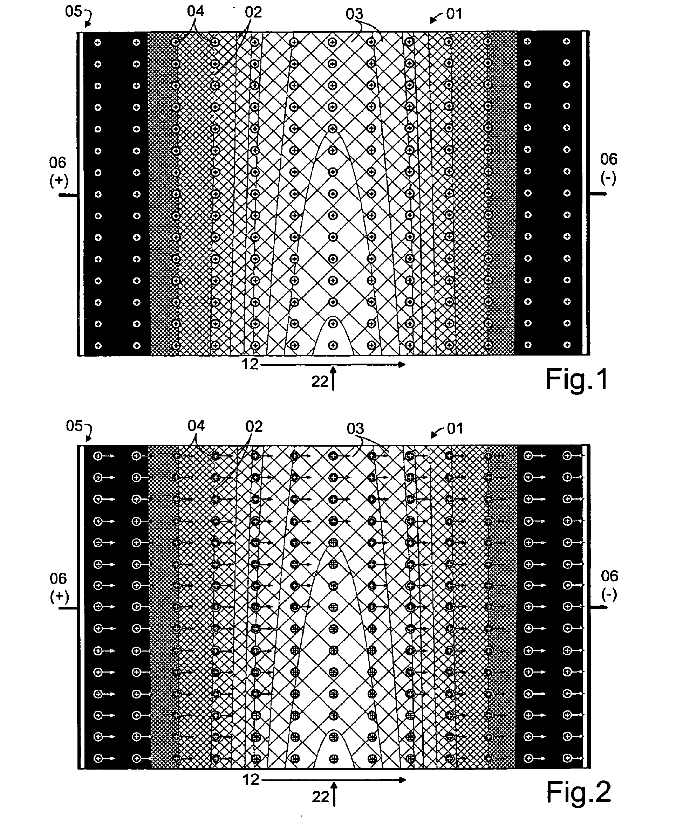

In der **FIGUR 1** ist schematisch im Querschnitt eine 100 µm dicke Fotolackschicht **01** aus SU8, einem chemisch verstärkten polymeren Fotolack auf Epoxidharz-Basis mit einer Negativ-Entwicklung, angedeutet. Eingezeichnet sind berechnete Isodosislinien **02** (Bereiche gleicher Beleuchtungsintensität, d.h. Photonendichte), die sich bei einer UV-Belichtung (Pfeil Belichtungsrichtung 22) durch eine 10 µm breite Spaltblende mit einem Abstand von 700 µm zur Fotolackschicht **01** ergeben. Deutlich ist zu erkennen, wie sich anhand der an der Spaltblende auftretenden Beugung verschiedene kegelförmige Intensitätsbereiche **03** ausbilden. Die unterschiedliche Photonendichte erzeugt in der Fotolackschicht **01** eine unterschiedliche Dichte an freien Ladungsträgern **04** als fotoaktive Komponente und damit eine unterschiedliche Vernetzung. Bei SU8 werden freie Ladungsträger **04** in Form von Kationen bzw. Protonen erzeugt, die in unvernetzter Form schematisch als Kreise mit einem "+" dargestellt sind. Dabei ist der Übersichtlichkeit halber nur die statische Gleichverteilung der Protonen dargestellt, Dichteveränderungen aufgrund unterschiedlicher Belichtungsintensität sind nicht eingezeichnet, entsprechen aber den Bereichen unterschiedlicher Photonendichte - je mehr Photonen vorhanden sind, desto mehr freie Ladungsträger **04** werden auch erzeugt und initiieren eine Vernetzung. Anhand der Belichtungsparameter können also bereits sehr unterschiedliche Vernetzungsintensitäten in der Fotolackschicht **01** hervorgerufen werden. Da SU8 ein Negativ-Fotolack ist, bei dem im Entwicklungsschritt die unbelichteten Bereiche vollständig und die weniger belichteten Bereiche in Abhängigkeit von ihrem Belichtungsgrad entfernt werden, ergibt sich eine entsprechend kontinuierlich verlaufende dreidimensionale Kegelformation nach der Entwicklung.

Bei dem Verfahren nach der Erfindung befindet sich die Fotolackschicht **01** im gewählten Ausführungsbeispiel während der Belichtung in einem elektrischen Feld **05** mit zwei gegenüberliegenden Elektroden **06** nach Sandwichart. Das elektrische Feld **05** (Stromrichtung/Polung **12)** ist rechtwinklig zur Belichtungsrichtung **22** angelegt. Dadurch werden die in der Fotolackschicht **01** erzeugten freien Ladungsträger **04** ausgerichtet und entsprechend ihrer Ladungsart gezielt zu einer orientierten Wanderung entlang der Feldlinien veranlasst. Da die elektrische Ausrichtung der freien Ladungsträger **04** während der Belichtung und/oder der unmittelbar darauf folgenden Erwärmung erfolgt, treten die Prozesse der Vernetzungsreaktion und der natürlichen und wärmeinduzierten Diffusion der freien Ladungsträger **04** und Fotosäure-Moleküle durch die Fotolackschicht **01** mit einander in Konkurrenz. Dieses ist in der FIGUR **2** angedeutet. Dabei werden bereits vernetzte freie Ladungsträger **04** mit einem Kreuz im Kreis angedeutet, noch nicht vernetzte freie Ladungsträger **04** mit einem Plus im Kreis und noch nicht vernetzte, wandernde freie Ladungsträger **04** mit einem Plus im Kreis mit einem Pfeil für die Orientierung dargestellt. Ergebnis dieser Konkurrenzsituation ist, dass sich die noch nicht vernetzten freien Ladungsträger **04** bzw. Protonen in Richtung der Elektroden **06** bewegen. Dargestellt ist eine Wanderung von positiven freien Ladungsträgern **04** (im Ausführungsbeispiel Kationen bzw. Protonen) in Richtung auf die negative Elektrode **06.** Es ergibt sich eine rechtwinklig zur Belichtungsrichtung **22** ausgerichtete Wanderung (kleine Pfeile an den freien Ladungsträgern **04).** Dadurch entstehen säurearme und säurereiche bzw. protonenarme und protonenreiche Gebiete in der Fotolackschicht **01.** Aufgrund dessen ist die darauf folgende Vernetzungsreaktion deutlich in eine Richtung (im gezeigten Ausführungsbeispiel in Richtung auf die negative Elektrode **06)** hin verschoben, und es können Strukturflanken erzeugt werden, die deutlich von einer lediglich vertikal verlaufenden (binären) Struktur abweichen. Analog zur Wanderung von positiven Fotosäure-Spaltprodukte (Kationen) in Richtung auf die negative Elektrode **06** (-) wandern negative Fotosäure-Spaltprodukte (Anionen) in Richtung auf die positive Elektrode **06** (+).

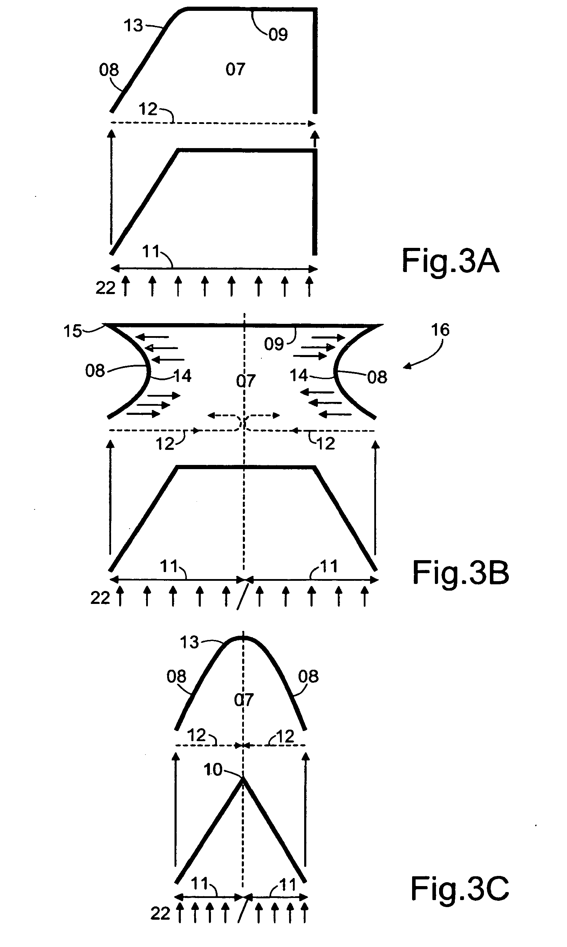

Aufgrund der Ansteuerbarkeit der Elektroden **06** des elektrischen Feldes 05 und der Koordination mit der Belichtung durch Lichteinstrahlung können mit dem Verfahren nach der Erfindung auch sehr unterschiedliche Strukturformen durch teilweises Belichten der Strukturen mit Wechsel der Stromrichtung, manuelles Umschalten der Elektroden **06** während der Belichtung oder elektrische Wechselfelder hoher Frequenzen erzeugt werden. Darüber hinaus können diese Möglichkeiten noch mit beliebig erzeugten, verschiedenen Belichtungsdosen kombiniert werden. In den **FIGUREN 3A, 3B,** 3C sind beispielhaft mit dem Verfahren nach der Erfindung erreichbare Strukturformen schematisch aufgezeigt, die durch Abstimmung der Elektrodenansteuerung und der Belichtungsführung erreicht werden können. Ergebnis dieser Technik sind konvexe, konkave und linear ansteigende 3D-Strukturen, die sich nur mit Hilfe des Verfahrens nach der Erfindung, basierend auf der Grauton-Lithografie gezielt herstellen lassen.

Dabei zeigen die **FIGUREN 3A,3B,3C** unten im Schnitt dreidimensionale Strukturen, die durch Grauton-Lithografie ausschließlich unter Variation der Belichtung herstellbar sind. In **FIGUR 3A** ist eine Rippe **07** mit einer schrägen Flanke **08** und einer Oberkante 09 dargestellt. Die **FIGUR 3B** zeigt eine trapezförmige Rippe **07** mit zwei schrägen Flanken **08** beidseits der Oberkante **09.** Die **FIGUR 3C** zeigt eine dreieckige Rippe **07** mit zwei schrägen Flanken **08,** die einander in einem Scheitelpunkt **10** berühren. Dabei werden zur Erzeugung der Strukturen gemäß **FIGUREN 3B, 3C** zwei aneinander grenzende Belichtungsfelder **11** festgelegt. Die **FIGUREN 3A,3B,3C** oben zeigen die erzeugbaren Strukturen unter Anwendung von elektrischen Feldern **05** gemäß der Erfindung. Eine Stromrichtung **12** (Polung) ist jeweils oberhalb der **FIGUREN 3A, 3B** und **3C** angedeutet.

In der **FIGUR 3A** ist ein Belichtungsfeld **11** (mit Belichtungsrichtung **22)** vorgesehen, dem eine konstante Stromrichtung **12** (mit der jeweils gezeigten Stromrichtung **12** stimmt auch die Richtung der gezielt hervorgerufenen Wanderung der Fotosäure-Moleküle **04** bzw. der nicht vernetzten Protonen überein) rechtwinklig überlagert wird. Zu erkennen ist, dass ein solches elektrisches Feld **05** angelegt wird, dass die damit hervorgerufene orientierte Wanderung der Fotosäure-Moleküle **04** bzw. der nicht vernetzten Protonen eine Verrundung **13** zwischen der schrägen Flanke **08** und der Oberkante **09** ergibt. Dabei wird im Bereich der Flanke **08** kein elektrisches Feld 05 angelegt, sodass die Flanke **08** in ihrer Steigung keine Veränderung gegenüber der reinen Belichtung erfährt (was aber ebenfalls ohne weiteres möglich wäre). Erst im Bereich der Ecke wird durch Anlegen des elektrischen Felds **05** die Verrundung **13** durch eine forcierte Wanderung der Fotosäure-Moleküle **04** bzw. der nicht vernetzten Protonen hervorgerufen.

In der **FIGUR 3B** sind zwei Belichtungsfelder **11** mit wechselnder Stromrichtung **12** vorgesehen. Dabei ändert die Stromrichtung 12 in Abhängigkeit von der Zeit auch in jedem Belichtungsfeld **11** ihre Orientierung (Umkehrung des Pfeils). Im linken Belichtungsfeld 11 wird zunächst ein ansteigender Strom in Richtung Mitte aufgeprägt. Bei Erreichen des Scheitelpunkts wird die Stromrichtung **12** dann umgekehrt. Das elektrische Feld **05** wird in Richtung auf die oberen Ecken dann verstärkt, da die oberen Ecken des sich ergebenden komplexen Ambossprofils **16** über den unteren Ecken liegen und damit weiter außen als die oberen Ecken bei dem einfachen Trapez. Analog wird bei dem rechten Belichtungsfeld **11** vorgegangen. Die kleinen Pfeile deuten die jeweils erzeugte Protonenwanderung an. Zu erkennen ist die rechtwinklige Überlagerung der Stromrichtung (Polung) **12** mit der Belichtungsrichtung **22.** Auf diese Weise wird jeweils eine konkave Ausbeulung **14** der Flanken **08** erreicht. Eine Verrundung zur Oberkante 09 wird hier nicht erzeugt. Dadurch ergibt sich eine besonders scharfe Abrisskante **15** des komplexen Ambossprofils **16.**

In der **FIGUR 3C** sind wiederum zwei Belichtungsfelder **11** (Belichtungsrichtung **22)** mit wechselnder rechtwinklig überlagerter Stromrichtung **12** vorgesehen. Durch entsprechendes Erhöhen des Stroms und Umkehren der Stromrichtung **12** kann eine Verrundung **13** des Scheitelpunkts 10 der dreieckigen Rippe **07** erreicht werden.

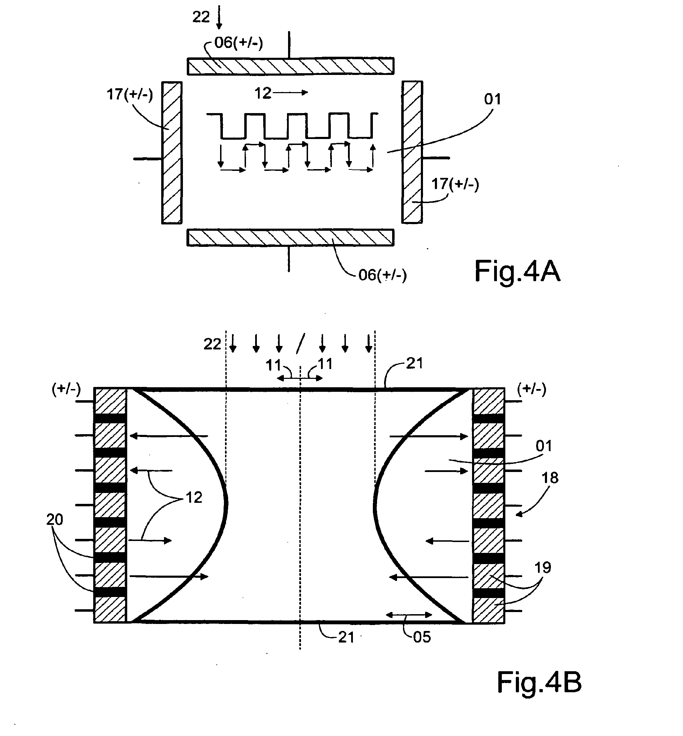

Die **FIGUR 4A** zeigt im Querschnitt eine Anordnung von jeweils zwei Elektroden **06** (die eine orientierte Wanderung der freien Ladungsträger **04** in Belichtungsrichtung **22 -** wie aus dem Stand der Technik bekannt - hervorrufen) und zwei weiteren Elektroden 17 mit einer 90°-Drehung zueinander an einer Lackschicht 01. Durch alternierendes Betreiben der elektrischen Felder 05 können mäanderförmige Strukturen erzeugt werden. Die Belichtung erfolgt von oben (Belichtungsrichtung **22).** Die kleinen Pfeile zeigen wiederum die Richtung der verstärkten Protonenwanderung an. Alternativ können die Elektrodenpaare auch unter einem anderen Winkel zueinander angeordnet sein. Weiterhin können alternativ gemäß Figur **4B** (Querschnitt) auch mehrere Elektroden **19** übereinander angeordnet sein. Es ergibt sich ein Elektroden/Isolator-Sandwich **18.** Die Fotolackschicht 01 wird durch Ober- und Unterseite **21** begrenzt. Gezeigt (maßstabsverzerrt) ist eine 100 µm dicke Fotolackschicht **01** mit einem Sandwich aus 50 nm Goldschichten **19** (elektrisch leitend) mit dazwischen liegenden 10 nm Siliciumnitridschichten 20 (elektrisch nicht leitend). Durch die Vielzahl der Elektroden (in Form der Goldschichten **19)** an der Seite der Fotolackschicht **01** können mehrere elektrische Felder **05** gleichzeitig in ihren Polungen und Feldstärken variiert werden (die kleinen Pfeile deuten wiederum die forcierte Richtung der Protonenwanderung an, die Pfeilspitzen zeigen die Polung **12** an (rechtwinklig zur Belichtungsrichtung **22,** zwei Belichtungsfelder **11** von der Taillenbreite des Ambossprofils), die Länge der Pfeile symbolisiert die Stärke des jeweils zwischen den als Elektrodenpaar zusammengehörigen Goldschichten **19** erzeugten elektrischen Feldes 05). Beispielsweise können mehrere hundert Schichten abgewechselt werden. Durch eine solche Sandwichschichtung können besonders komplexe Strukturen besonders einfach und schnell erzeugt werden. Das gezeigte Ambossprofil wird dann durch eine zur Mitte der Fotolackschicht **01** hin sehr geringe Feldstärke (geringe Protonenwanderung) und an der Ober- und Unterseite **21**,durch eine sehr hohe Feldstärke (starke Protonenwanderung) erzeugt. Das mittlere Elektrodenpaar aus Goldschichten **19** im Elektroden/Isolator-Sandwich **18** wird im gezeigten Beispiel nicht betrieben. Außerhalb der Taille des Ambossprofils erfolgt auch keine Beleuchtung, sodass keine Protonen zur Vernetzung erzeugt werden.

Somit ist zu erkennen, dass mit dem Verfahren nach der Erfindung äußerst komplexe dreidimensionale Strukturen in einfacher Weise hochgenau, aber durch die einfache Parametrierung beliebig reproduzierbar erhältlich sind. Die Reichweite geht von geraden Profilen bis hin zu konvex und konkav geformten Strukturen.

Die sich aus fotolithografischen Verfahren nach der Erfindung ergebenden Vorteile und Neuheiten sind im Folgenden noch einmal zusammengefasst:
- drei-dimensionale Strukturen, insbesondere auch konvexe, konkave, konisch geformte und ansteigende Profile, können einfach und reproduzierbar realisiert werden,
- die Realisierung erfolgt nur durch einfache Kombination von chemisch verstärkten Fotolacken (z.B. SU8) und der Anwendung elektrischer Felder,
- die Realisierung kann mittels einfacher UV-Lithografie erfolgen,
- es ergeben sich viele Anwendungsbereiche für hochkomplexe "echte" 3D-Strukturen, beispielsweise für die Halbleitertechnologie, Nanofluidik und Medizintechnik.

Das fotolithografische Verfahren nach der Erfindung arbeitet, wie an den Ausführungsbeispielen verdeutlicht, zuverlässig bei allen auf SU8 basierenden Fotolacken mit einer Erzeugung von freien Ladungsträgern. Andere Fotolacke beruhen nicht auf einer Photoreaktion (keinen lonenbildung, sondern kovalente Bindungen), sodass grundsätzlich anzunehmen wäre, dass keine freien Ladungsträger entstehen, die in einem elektrischen Feld manipuliert werden können. Das fotolithografische Verfahren nach der Erfindung kann hier aber als Messverfahren eingesetzt werden, um zu prüfen, ob im Laufe der Vernetzung doch freie Ladungsträger entstehen, die dann entsprechend in einem elektrischen Feld beeinflusst werden können. Das fotolithografische Verfahren nach der Erfindung trägt dann zum weiteren Verständnis nicht ionischer Fotosäuregeneratoren bei.

### BEZUGSZEICHENLISTE

- 01: Fotolackschicht
- 02: Isodosislinie
- 03: Intensitätsbereich
- 04: freier Ladungsträger
- 05: elektrisches Feld
- 06: Elektrode
- 07: Rippe
- 08: Flanke
- 09: Oberkante
- 10: Scheitelpunkt
- 11: Belichtungsfeld
- 12: Stromrichtung/Polung
- 13: Verrundung
- 14: Ausbeulung
- 15: Abrisskante
- 16: Ambossprofil
- 17: weitere Elektrode
- 18: Elektroden/Isolator-Sandwich
- 19: Goldschicht
- 20: Siliciumnitridschicht
- 21: Ober- und Unterseite
- 22: Belichtungsrichtung

## Patentansprüche

1. Fotolithografisches Verfahren zum Ausbilden einer dreidimensionalen Struktur in einer Fotolackschicht mit den Verfahrensschritten:
• Bereitstellen einer Fotolackschicht (01) aus einem chemisch verstärkten Fotolack mit mindestens einem Fotosäuregenerator zur Erzeugung von freien Ladungsträgern (04) bei Belichten oberhalb einer Schwellwertdosis,
• Belichten zumindest eines Belichtungsfelds (11) der Fotolackschicht (01) mit einer stufenweise oder kontinuierlich veränderbaren Belichtungsdosis oberhalb der Schwellwertdosis des Fotosäuregenerators,
• Anregen einer orientierten Wanderung der freien Ladungsträger (04) in der Fotolackschicht (01) durch Anlegen zumindest eines in seiner Polung und seiner Feldstärke einstellbaren elektrischen Feldes (05) an die Fotolackschicht (01), wobei die freien Ladungsträger (04) eine Vernetzung der Fotolackschicht (01) bewirken, und
• Entwickeln der vernetzten Fotolackschicht (01) durch Entfernen der
löslichen Bestandteile der Fotolackschicht (01),
**GEKENNZEICHNET DURCH**
Anregen der orientierten Wanderung der freien Ladungsträger (04) in der Fotolackschicht (01) rechtwinklig zur Belichtungsrichtung **durch** Anlegen zumindest eines in seiner Polung und seiner Feldstärke einstellbaren elektrischen Feldes (05) an die Fotolackschicht (01) rechtwinklig zur Belichtungsrichtung und
eine Koordination des Einstellens des zumindest einen elektrischen Felds (05) mit dem Belichten **durch** Belichten des zumindest einen Belichtungsfelds (11) der Fotolackschicht (01) während einer solchen Einstellung der Polung (12) und/oder der Feldstärke des zumindest einen angelegten elektrischen Felds (05), dass **durch** die angeregte orientierte Wanderung der freien Ladungsträger dreidimensionale Strukturen mit Verrundungen (13) ausgebildet werden.

2. Fotolithografisches Verfahren nach Anspruch 1,
**GEKENNZEICHNET DURCH**
Anlegen mehrerer elektrischer Felder (05) senkrecht, winklig und/oder parallel zueinander.

3. Fotolithografisches Verfahren nach Anspruch 1 oder 2 ,
**GEKENNZEICHNET DURCH**
Anlegen des zumindest einen elektrischen Feldes (05) auch während des Erwärmens der Fotolackschicht (01).

4. Fotolithografisches Verfahren nach zumindest einem der Ansprüche 1 bis 3, **GEKENNZEICHNET DURCH**
Belichten unterschiedlicher Belichtungsfelder (11) der Fotolackschicht (01).

5. Fotolithografisches Verfahren nach zumindest einem der Ansprüche 1 bis 4, **GEKENNZEICHNET DURCH**
Verändern der relativen Lage zwischen der Fotolackschicht (01) und dem elektrischen Feld (05) während des Anlegens des zumindest einen elektrischen Feldes (05).

6. Fotolithografisches Verfahren nach zumindest einem der Ansprüche 1 bis 5, **GEKENNZEICHNET DURCH**
Belichten mit UV-Licht.

7. Fotolithografisches Verfahren nach zumindest einem der Ansprüche 1 bis 6, **GEKENNZEICHNET DURCH**
Belichten **durch** eine Belichtungsmaske hindurch.

8. Fotolithografisches Verfahren nach zumindest einem der Ansprüche 1 bis 7, **GEKENNZEICHNET DURCH**
Bereitstellen einer Fotolackschicht (01) aus einem polymeren Negativ-Photo-resist auf Epoxidharz-Basis mit einer Erzeugung von Kationen als freigesetzte lonen zur Fotolackvernetzung.

9. Fotolithografisches Verfahren nach zumindest einem der Ansprüche 1 bis 8, **GEKENNZEICHNET DURCH**
Bereitstellen einer Fotolackschicht (01) auf einem Substrat oder aus einer freitragenden Fotolackfolie.

## Claims

1. A photolithographic method for constructing a three-dimensional structure in a photo-resist layer, with the following steps in the method:
• providing a photo-resist layer (01) from a chemically amplified photo-resist with at least one photo-acid generator in order to produce free charge carriers (04) upon exposure above a threshold dose;
• exposing at least one exposure field (11) of the photo-resist layer (01) with a stepped or continuously variable exposure dose above the threshold dose of the photo-acid generator;
• exciting orientated diffusion of the free charge carriers (04) in the photo-resist layer (01) by applying at least one electric field (05) the polarity and field strength of which can be varied to the photo-resist layer (01), whereupon the free charge carriers (04) cause curing of the photo-resist layer (01); and
• developing the cured photo-resist layer (01) by removing the
soluble components of the photo-resist layer (01);
**CHARACTERIZED IN THAT**
orientated diffusion of the free charge carriers (04) in the photo-resist layer (01) is excited at right angles to the direction of exposure by applying at least one electric field (05) the polarity and field strength of which can be varied to the photo-resist layer (01) at right angles to the direction of exposure and adjustment of the at least one electric field (05) is coordinated with the exposure by exposing the at least one exposure field (11) of the photo-resist layer (01) during said adjustment of the polarity (12) and/or the field strength of the at least one applied electric field (05), such that three-dimensional structures with roundings (13) are constructed by the excited orientated diffusion of the free charge carriers.

2. The photolithographic method as claimed in claim 1,
**CHARACTERIZED IN THAT**
a plurality of electric fields (05) are applied perpendicularly, at an angle and/or parallel to each other.

3. The photolithographic method as claimed in claim 1 or claim 2, **CHARACTERIZED IN THAT**
the at least one electric field (05) is also applied during heating of the photo-resist layer (01).

4. The photolithographic method as claimed in at least one of claims 1 to 3, **CHARACTERIZED IN THAT**
different exposure fields (11) of the photo-resist layer (01) are exposed.

5. The photolithographic method as claimed in at least one of claims 1 to 4, **CHARACTERIZED IN THAT**
the relative position of the photo-resist layer (01) and the electric field (05) is altered during application of the at least one electric field (05).

6. The photolithographic method as claimed in at least one of claims 1 to 5, **CHARACTERIZED IN THAT**
the exposure uses UV light.

7. The photolithographic method as claimed in at least one of claims 1 to 6, **CHARACTERIZED IN THAT**
exposure occurs through a reticle.

8. The photolithographic method as claimed in at least one of claims 1 to 7, **CHARACTERIZED IN THAT**
a photo-resist layer (01) is prepared from a polymeric negative photo-resist based on an epoxy resin with cations being produced as the ions liberated for the purposes of photo-resist curing.

9. The photolithographic method as claimed in at least one of claims 1 to 8, **CHARACTERIZED IN THAT**
a photo-resist layer (01) is provided on a substrate or from a self-supporting photo-resist film.

## Revendications

1. Procédé photolithographique pour former une structure tridimensionnelle dans une couche de laque photosensible avec les étapes de procédé de :
• préparation d'une couche de laque photosensible (01) à partir d'une laque photosensible chimiquement renforcée avec au moins un générateur photoacide pour produire des porteurs de charge (04) libres lors de l'exposition au-dessus d'une dose de valeur seuil,
• exposition d'au moins un champ d'exposition (11) de la couche de laque photosensible (01) à une dose d'exposition modifiable progressivement ou en continu au-dessus de la dose de valeur seuil du générateur photoacide,
• activation d'une migration orientée des porteurs de charge (04) libres dans la couche de laque photosensible (01) par application d'au moins un champ électrique (05), réglable dan sa polarisation et son intensité de champ, à la couche de laque photosensible (01), les porteurs de charge (04) libres créant une réticulation de la couche de laque photosensible (01) et
• développement de la couche de laque photosensible (01) réticulée par enlèvement des composants solubles de la couche de laque photosensible (01),
**caractérisé en ce que** des structures tridimensionnelles avec des arrondis (13) sont constituées par la migration orientée activée des porteurs de charge libres du fait de l'activation de la migration orientée des porteurs de charge (04) libres dans la couche de laque photosensible (01) perpendiculairement au sens d'exposition par application d'au moins un champ électrique (05) réglable dans sa polarisation et son intensité de champ à la couche de laque photosensible (01) perpendiculairement au sens d'exposition et du fait d'une coordination du réglage d'au moins un champ électrique (05) avec l'exposition par exposition d'au moins un champ d'exposition (11) de la couche de laque photosensible (01) pendant un tel réglage de polarisation (12) et/ou du champ d'intensité d'au moins un champ électrique (05) appliqué.

2. Procédé photolithographique selon la revendication 1 **caractérisé en ce qu'**on applique plusieurs champs électriques (05) perpendiculairement, angulairement et/ou parallèlement l'un par rapport à l'autre.

3. Procédé photolithographique selon la revendication 1 ou 2 caractérisé en qu'on applique au moins le champ électrique (05) également pendant le réchauffement de la couche de laque photosensible (01).

4. Procédé photolithographique selon au moins une quelconque des revendications 1 à 3 **caractérisé en ce qu'**on expose différents champs d'exposition (11) de la couche de laque photosensible (01).

5. Procédé photolithographique selon au moins une quelconque des revendications 1 à 4 **caractérisé en ce qu'**on modifie la position relative entre la couche de laque photosensible (01) et le champ électrique (05) pendant l'application d'au moins un champ électrique (05).

6. Procédé photolithographique selon au moins une quelconque des revendications 1 à 5 **caractérisé en ce qu'**on effectue une exposition avec une lumière UV.

7. Procédé photolithographique selon au moins une quelconque des revendications 1 à 6 **caractérisé en ce qu'**on effectue une exposition à travers un masque d'exposition.

8. Procédé photolithographique selon au moins une quelconque des revendications 1 à 7 **caractérisé en ce qu'**on prépare une couche de laque photosensible (01) à partir d'une laque photosensible négative polymère à base de résine époxy avec une production de cations en tant qu'ions libérés pour la réticulation de la laque photosensible.

9. Procédé photolithographique selon au moins une quelconque des revendications 1 à 8 **caractérisé en ce qu'**on prépare une couche de laque photosensible (01) sur un substrat ou à partir d'une feuille de laque photosensible à portée libre.
